(19) Europäisches Patentamt / European Patent Office / Office européen des brevets

(11) **EP 4 057 067 A1**

(12) # EUROPEAN PATENT APPLICATION
published in accordance with Art. 153(4) EPC

(43) Date of publication:
**14.09.2022 Bulletin 2022/37**

(21) Application number: **20885957.9**

(22) Date of filing: **23.10.2020**

(51) International Patent Classification (IPC):
**G03F 7/20** (2006.01)   **G02B 1/02** (2006.01)
**G02B 5/00** (2006.01)

(52) Cooperative Patent Classification (CPC):
**G02B 1/02; G02B 5/00; G03F 7/20**

(86) International application number:
**PCT/JP2020/039865**

(87) International publication number:
**WO 2021/090706 (14.05.2021 Gazette 2021/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.11.2019 JP 2019203528**

(71) Applicants:
• **OSAKA UNIVERSITY**
**Suita-shi**
**Osaka 565-0871 (JP)**
• **Kurashiki Boseki Kabushiki Kaisha**
**Kurashiki-shi, Okayama 710-0054 (JP)**

(72) Inventors:
• **MIZUTANI, Yasuhiro**
**Suita-shi, Osaka 565-0871 (JP)**
• **TAKAYA, Yasuhiro**
**Suita-shi, Osaka 565-0871 (JP)**
• **NAKANISHI, Hiroki**
**Suita-shi, Osaka 565-0871 (JP)**
• **EZAKI, Ryu**
**Suita-shi, Osaka 565-0871 (JP)**
• **MAKIURA, Yoshihiko**
**Neyagawa-shi, Osaka 572-0823 (JP)**

(74) Representative: **Dehns**
**St. Bride's House**
**10 Salisbury Square**
**London EC4Y 8JD (GB)**

(54) **MICROSTRUCTURE AND METHOD FOR MANUFACTURING SAME**

(57)    The present invention relates to a microstructure 20 having pores 22 on its surface or inside. The microstructure is a sheet containing an energy ray active resin 21. The pores 22 are formed in a vertical array and are in a formation pattern with a Talbot distance being specified by Formula 1 below:

[Formula 1]

$$Z_T = (2nd^2) / \lambda \qquad \text{[Formula 1]}$$

where $Z_T$ represents a Talbot distance (nm), n represents a refractive index, d represents a pitch distance (nm), and $\lambda$ represents a light wavelength (nm). The pores have a periodic shape in the planar direction. Thus, the present invention provides three-dimensional microfabricated structures through which the periodicity is controlled.

FIG. 4

**Description**

Technical Field

The present invention relates to microstructures processed using the Talbot effect and a method for producing the same.

Background Art

Submicron three-dimensional structures have drawn attention recently. Examples of the submicron three-dimensional structures include microstructured parts for semiconductor devices and microelectromechanical systems (MEMS), biomimetic structures that imitate functional microstructures of living organisms, and nanostructured photonic crystals composed of substances with different refractive indexes arranged at intervals almost the same as light wavelength. These submicron three-dimensional structures, particularly those having a periodic structure, are attracting attention as functional materials. Techniques for fabricating microstructures include lithography, etching, nanoimprint, laser micromachining, atomic manipulation using an atomic force microscope (AFM), and self-organization. These techniques require longer processing time as structures are formed multidimensionally, and improved processing efficiency is required. A high degree of freedom and high accuracy in processing are also required, along with more complicated structures, to control the periodic structure as desired. However, the efficiency and the degree of freedom in processing are in a trade-off relationship, and technologies for fabricating multi-dimensional microstructures with a simple technique have not yet been established and are under development. Together with the improvement in the processing accuracy, it also is desired to broaden a processing area to the order of millimeters in the production of microstructures.
One simple method for producing microstructures is a three-dimensional lithography technique using a resist resin material. Specifically, three-dimensional lithography using the Talbot effect facilitates the formation of a periodic pattern in a large area at once by using a specific wavelength and a diffraction grating, and highly improves the processing efficiency. In the lithography using the Talbot effect, however, the degree of freedom in processing is low, because the parameters for controlling the periodicity are the wavelength and the grating pitch, and thus the period control is limited to two dimensions. No technologies have been established for processing three-dimensional structures into desired shapes without limiting the processing area to the "surface" or "inside".
Patent Document 1 discloses lithography techniques using the Talbot effect. These techniques are intended for processing with use of etching screen masks and do not involve internal processing of structures. Patent Document 2 discloses masks and pattern forming methods that enable highly accurate patterns to be formed using the Talbot effect, but the technique is not intended for fabrication of structures. Patent Document 3 discloses formation of periodic recesses or pores by etching, but it is not easy to fabricate microstructures with this technique. Non-Patent Document 1 proposes a structure in which metal nanoparticles are dispersed by applying stereolithography using the Talbot effect, but the technique has not reached fabricating clear layer structures using the Talbot effect. Non-Patent Document 2 discloses fabrication of nanostructures in a large area in one-dimensional layer structures and two-dimensional periodic structures, but the accuracy and the maintenance of the structures are unsatisfactory, and the technique has not reached fabricating periodic structures. Non-Patent Document 3 and Non-Patent Document 4 suggest the possibility of fabricating three-dimensional periodic nanostructures based on the results of numerical analysis of multiple exposures, but the accuracy and the maintenance of the structures are unsatisfactory, and the technique has not yet reached fabricating commercially practical structures.

Prior Art Documents

Patent Documents

Patent Document 1: WO 2016-190247
Patent Document 2: JP 2015-169803 A
Patent Document 3: JP 2006-343671 A

Non-Patent Documents

Non-Patent Document 1: Fabricating of metallic three-dimensional nanostructure using Talbot effect (1st report), Influence analysis of grating shape and verification of fabrication process (Proceedings of the Japan Society for Precision Engineering in Spring, 2016)
Non-Patent Document 2: Three-dimensional lithography in a large area using Talbot effect (1st report), Fabrication of functional devices using wave-front control and standing-wave field (Proceedings of the Japan Society for Precision Engineering in Spring, 2017)
Non-Patent Document 3: Three-dimensional lithography in a large area using Talbot effect (2nd report), Fabrication of 3D nano-periodic structure using multiple exposure (Proceedings of the Japan Society for Precision Engineering in Spring, 2019)
Non-Patent Document 4: Fabrication of 3D Nano-Periodic Structure Using Multiple Exposure Lithography by Talbot Effect (Journal of the Japan Society for Precision Engineering, Vol. 85, No. 8, 2019)

Disclosure of Invention

Problem to be Solved by the Invention

Fabrication of such three-dimensional structures using resist resins is receiving attention and has been researched as a useful technique as described above, but they are not yet commercially practical because the periodicity of the three-dimensional structures is difficult to control.
To solve the above conventional problems, the present invention provides three-dimensional microfabricated structures having controlled periodicity from the surface to the inside.

Means for Solving Problem

The present invention relates to a microstructure having pores on its surface or inside,

wherein the microstructure is a sheet containing an energy ray active resin, the pores are formed in a vertical array, the pores in the microstructure are in a formation pattern with a Talbot distance being specified by Formula 1 below:

$$[\text{Formula 1}]$$

$$Z_T = (2nd^2) / \lambda$$

where $Z_T$ represents a Talbot distance (nm), n represents a refractive index, d represents a pitch distance (nm), and $\lambda$ represents a light wavelength (nm), and
the pores have a periodic shape in the planar direction and the vertical direction.

A method for producing the microstructure of the present invention is a method for producing the microstructure according to any of claims 1 to 6, including:

(1) applying an energy ray active resin to a substrate in a uniform thickness;
(2) prebaking (heating) the applied energy ray active resin layer;
(3) forming a pattern in the energy ray active resin layer obtained in (2) by placing a diffraction grating on an upper surface of the resin layer, and vertically irradiating the resin layer with energy ray through multiple exposures including exposure with at least one movement of the diffraction grating selected from rotation and shifting;
(4) chemically reacting the resin layer obtained in (3) with a developer to dissolve a portion where an energy ray exposure dose reaches or exceeds an energy ray curing threshold and cure a portion where the exposure dose is below the curing threshold, or to cure a portion where an energy ray exposure dose reaches or exceeds an energy ray curing threshold and dissolve a portion where the exposure dose is below the curing threshold; and
(5) washing the substrate obtained in (4) with pure water to remove the dissolved portion to obtain a microstructure.

Effect of the Invention

Multiple exposure, including exposure with rotation and/or shifting in the triaxial direction of energy ray obtained by the Talbot effect, enables formation of pores on the surface or inside of structures, whereby the microstructure of the present invention has controlled periodicity from the surface to the inside.

Brief Description of Drawings

[FIG. 1] FIG. 1A is a schematic cross-sectional view illustrating the basic concept of the present invention in which an exposure mask placed on the upper surface of a photoresist resin is irradiated with ultraviolet light (UV). FIG. 1B is a schematic cross-sectional view illustrating portions in the photoresist resin irradiated with light.
[FIG. 2] FIG. 2 is a schematic perspective view illustrating multiple exposures in one embodiment of the present invention. FIG. 2A is a schematic perspective view of the first exposure, and FIG. 2B is a schematic perspective view of the second exposure performed after rotation of a diffraction grating.
[FIG. 3] FIGS. 3A to 3E are schematic cross-sectional views and 3F is a schematic perspective view illustrating a production method in one embodiment of the present invention.
[FIG. 4] FIG. 4 is a schematic perspective view illustrating the inside of a microstructure of Example 1 of the present invention.
[FIG. 5] FIG. 5A is a schematic perspective view illustrating the inside of a microstructure of Example 2 of the present invention, and FIG. 5B is a photograph of the same.
[FIG. 6] FIG. 6 is a schematic perspective view illustrating the inside of a microstructure of Example 3 of the present invention.
[FIG. 7] FIG. 7 is a schematic perspective view illustrating the inside of a microstructure of Example 4 of the present invention.
[FIG. 8] FIG. 8 is a schematic perspective view illustrating the inside of a microstructure of Example 5 of the present invention.
[FIG. 9] FIG. 9A is a schematic perspective view illustrating the inside of a microstructure of Example 6 of the present invention, and FIG. 9B is a photograph of the same.
[FIG. 10] FIG. 10 is a schematic perspective view illustrating the inside of a microstructure of Example 7 of the present invention.

Description of the Invention

In the present invention, a sheet containing an energy ray active resin has pores formed in a vertical array. The pores may be present on the surface or inside of the sheet. The pores may be either closed or open. The pores in the microstructure are in a formation pattern with a Talbot distance being specified by Formula 1 above. The pores have a periodic shape in the planar direction.

The energy ray active resin is preferably a resist resin, and more preferably a positive resist resin. Portions in the positive resist resin exposed to energy ray dissolve in a solution, and such a property of the positive resist resin is suitable for microfabrication. A negative resist resin is exposed to high temperatures in postbaking, which strains resin and makes it difficult to produce microstructures with accurate periodicity.

The periodic shape preferably satisfies a grating pitch of wavelength $\lambda \leq$ grating pitch d and a pitch duty cycle of 0.2 to 0.7. This makes is possible to perform finer processing. The periodic shape is preferably a shape with regularity. Thus, microstructures with high uniformity are obtained.

The pores on the surface or inside of the microstructure include closed cells, pores penetrating through the front and back surfaces of the microstructure, grooves, holes, and other various pores.

The production method of the microstructure of the present invention includes the following steps:

(1) applying an energy ray active resin to a substrate in a uniform thickness;
(2) prebaking (heating) the applied energy ray active resin layer;
(3) forming a pattern in the energy ray active resin layer obtained in (2) by placing a diffraction grating on an upper surface of the resin layer, and vertically irradiating the resin layer with energy ray obtained by the Talbot effect through multiple exposures including exposure with at least one movement of the diffraction grating selected from rotation and shifting;
(4) chemically reacting the resin layer obtained in (3) with a developer to dissolve a resin portion where an energy ray exposure dose reaches or exceeds an energy ray curing threshold and leave a resin portion where the exposure dose is below the curing threshold, or leave a resin portion where an energy ray exposure dose reaches or exceeds an energy ray curing threshold and dissolve a resin portion where the exposure dose is below the curing threshold; and
(5) washing the resin obtained in (4) with pure water to remove the dissolved portion to obtain a microstructure.

An exemplary technique for the application of an energy ray active resin in a uniform thickness in (1) is spin coating. The spin coating enables thin and uniform application in a relatively small area.

Preferable conditions for the prebaking (heating) in (2) are the temperature of 0°C to 100°C and the time of about 1 to 5 minutes, according to the manufactures' recommendation.

Preferable conditions for the vertical irradiation with energy ray in the pattern forming step in (3) are the number of times of exposure of 2 to 10 times and the total exposure dose of 100 to 300 mJ/cm². The exposure with energy ray obtained by the Talbot effect may be any of the following: multiple exposures from the vertical direction; multiple exposures with shifting in the triaxial direction or rotation: or multiple exposures with shifting in the triaxial direction and rotation. For pattern formation, either the substrate or the diffraction grating may be moved, and any common positioning device may be used.

Postbaking (heating) is preferably performed between (3) and (4) to stabilize the exposed resist. Preferable conditions for the postbaking are the temperature of 30°C to 100°C and the time of about 1 to 60 minutes.

An exemplary technique for the washing in (5) is spin coating.

The following describes an exemplary microstructure of the present invention.

(1) The processible area is up to 20 mm per side in each exposure. Exposures are repeated to process a wider area.

(2) The processible thickness of the structure is 500 nm to 100 $\mu$m. The thickness is more preferably 700 nm to 50 $\mu$m, and further preferably 1 to 20 $\mu$m.

(3) The microfabricable pore length (length in the depth direction) is preferably 10 nm to 3000 nm. The length is more preferably 100 to 1500 nm.

(4) The periodicity of the structure is 1 to 20 times, and preferably about 1 to 10 times.

The Talbot effect used in the present invention is as follows.

(1) The Talbot effect is a phenomenon in which when a plane wave is incident upon the diffraction grating, diffracted light in the Fresnel region interferes with each other, and the periodic light intensity distribution is repeated three-dimensionally.

(2) By generating the periodic light intensity distribution by the diffraction grating and using it for exposure in lithography, a periodic microstructure can be three-dimensionally processed at once in a large area.

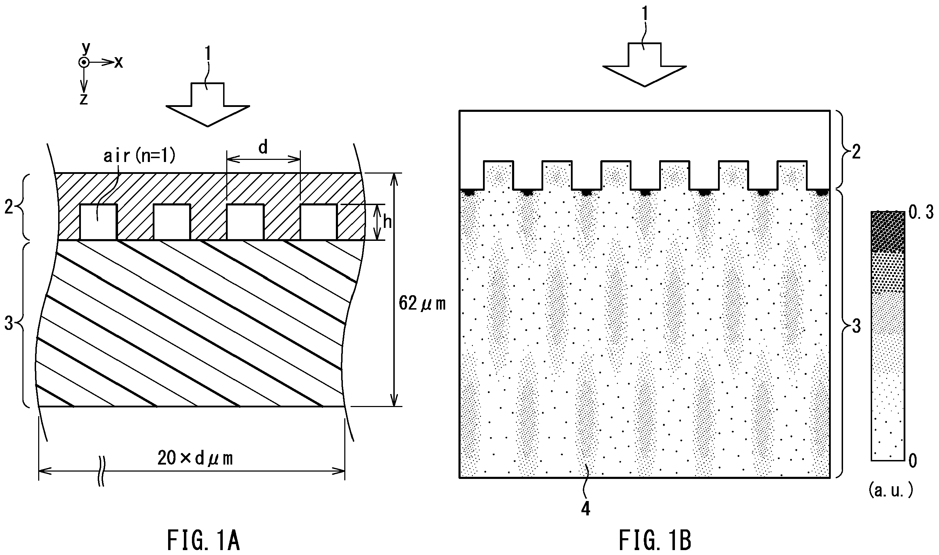

Hereinafter, the present invention will be described using drawings. In the following drawings, the same reference numeral denotes the same element. FIG. 1A is a schematic cross-sectional view illustrating the basic concept of the present invention in which an optical filter (exposure mask) 2 is placed on the upper surface of a photoresist resin 3 and irradiated with ultraviolet light (UV) 1. The photoresist resin 3 is a positive photoresist resin, and the optical filter (exposure mask) 2 is, e.g., a polycarbonate diffraction grating. A space between the photoresist resin 3 and the optical filter (exposure mask) 2 is defined as a distance 1. X and Y indicate the planar direction, and Z indicates the depth direction. Details are shown in the drawing. FIG. 1B is a schematic cross-sectional view illustrating light exposed portions 4, irradiated with light, in the photoresist resin 3. The pattern of dots indicates the exposed light intensity distribution, where the larger the number of dots, the higher the exposure intensity. The exposure intensity is standardized by the strongest light intensity and expressed in an arbitrary unit, a.u.

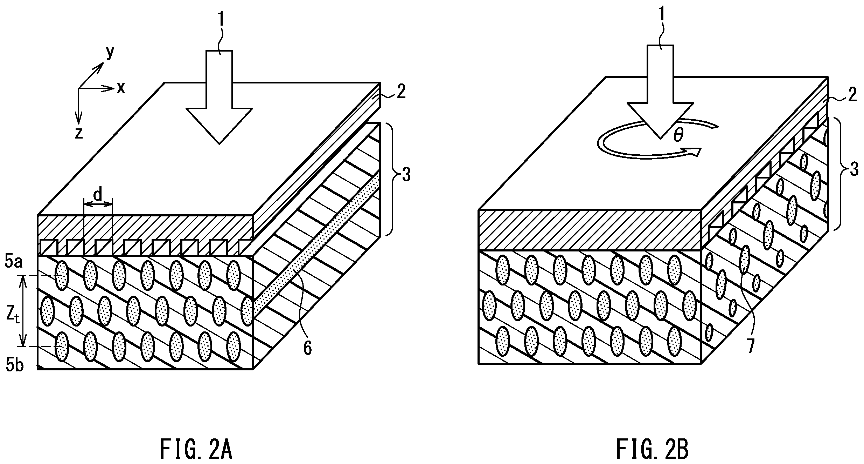

FIG. 2A is a schematic perspective view illustrating multiple exposures in one embodiment of the present invention. Vertically irradiating the surface of the photoresist resin 3 with ultraviolet light (UV) 1 yields light exposed portions 5a and 5b. $Z_T$ is a Talbot distance (nm). In FIG. 2A, the Talbot distance is a vertical distance (nm) between the center of an irradiated spot in the first row and the center of an irradiated spot in the third row, these irradiated spots being on the same irradiation line as viewed from the irradiation surface. By performing multiple exposures, light exposed portions 6 inside the resin continuously extend in the planar direction and become continuous pores when dissolved in the following step.

FIG. 2B is a schematic perspective view illustrating an exposure involving rotation. The rotation is the rotation of the photoresist resin 3 by a predetermined angle $\theta$. By performing exposure with rotation, light exposed portions 7 are independent of each other and become closed pores when dissolved in the following step.

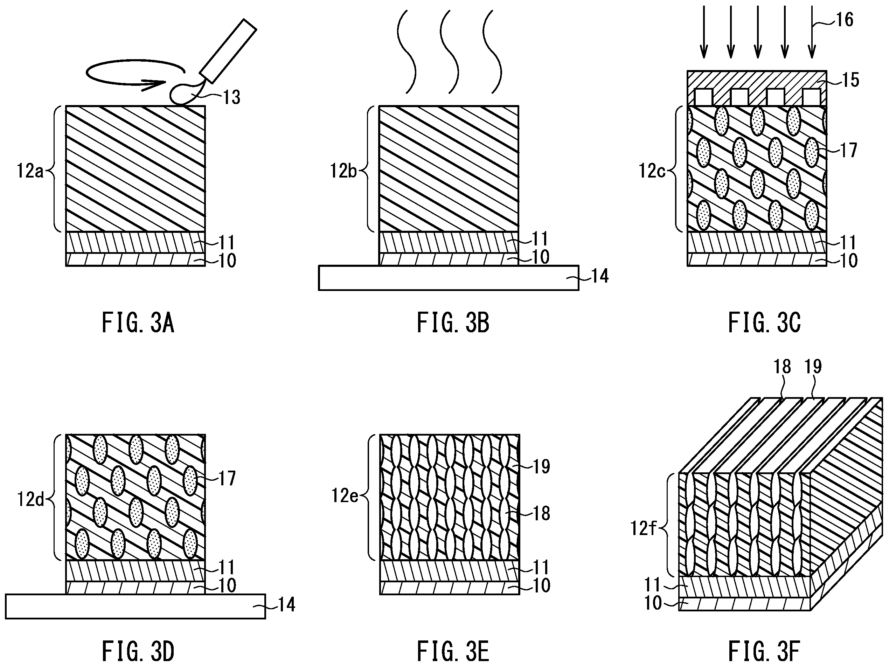

FIGS. 3A to 3E are schematic cross-sectional views and FIG. 3F is a schematic perspective view illustrating a production method in one embodiment of the present invention.

(1) FIG. 3A illustrates a state in which a sheet obtained by curing a 10-$\mu$m-thick photoresist resin is placed as a buffer layer 11 on a substrate 10, onto which a photoresist resin liquid 13 is applied by spin coating to form a photoresist resin layer 12a on the buffer layer 11.

(2) FIG. 3B illustrates a state in which the applied photoresist resin layer 12a is prebaked (heated) on a hot plate 14 to prepare a prebaked photoresist resin layer 12b.

(3) FIG. 3C illustrates a state in which an optical filter (exposure mask) 15 is placed on the photoresist resin layer 12b obtained in (2) and vertically irradiated with ultraviolet light (UV) 16 to form an exposure pattern 17 in a photoresist resin layer 12c.

(4) FIG. 3D illustrates a state in which the photoresist resin layer 12c obtained in (3) is stabilized by postbaking (heating). Next, FIG. 3E illustrates a state in which a postbaked (heated) photoresist resin layer 12d is chemically reacted with a developer by spin coating to dissolve a portion where an ultraviolet light (UV) exposure dose reaches or exceeds an energy ray curing threshold and cure a resin portion 19 where the exposure dose is below the curing threshold. By doing so, pores 18 are formed in a photoresist resin layer 12e.

(5) FIG. 3F illustrates a state in which the resin 19 obtained in (4) is washed with pure water to remove the dissolved portion to obtain a microstructure.

Preferable processing conditions according to the present invention are as follows.

(1) Resin material

A positive resist is preferably used. For example, a positive UV curable resin is preferred. A negative resist requires a step of arranging a buffer layer and involves high temperature exposure in postbaking, which strains the resin and makes it difficult to produce microstructures with accurate periodicity. The processing temperature (prebaking) of resin is preferably 0 to 100°C. This is the resin curing temperature range according to the resin manufactures' recommendation.

(2) Cleaning liquid: Any liquid that is noninvasive to the resin can be used. Pure water is preferably used.

(3) Light wavelength: Laser UV light is used. For example, $\lambda$ = 360 nm is used. The wavelength region is 0.1 nm to 380 nm. Examples of the energy ray include ultraviolet lights (UV-A, B, C), X-rays, and electron beams.

(4) Diffraction grating: One or more optical filters are used. For example, polycarbonate optical filters are used. The grating pitch is specified by wavelength $\lambda \leq$ grating pitch d. The pitch duty cycle is 0.2 to 0.7, and preferably 0.4 to 0.6. For example, the grating pitch is 747 nm, and the grating height is 150 nm. The DVD surface can be used as a diffraction grating. Examples of the diffraction grating other than DVDs include those described in Table 1.

[Table 1]

|  | The number of grooves (number/mm) | Pitch ($\mu$m) |
|---|---|---|
| GTU13-06 manufactured by Thorlabs, Inc. | 600 | 1.67 |
| GTU13-08 manufactured by Thorlabs, Inc. | 830 | 1.20 |
| GTU13-12 manufactured by Thorlabs, Inc. | 1200 | 0.833 |

(5) Processing pattern

A groove structure with regularity can be formed. The periodicity of the structure is changeable between 1 time and 20 times inclusive. The surface to be processed of the structure may be formed to have an acute angle, or flat.

(6) Processing characteristics

(a) Precise processing is performed by multiple exposures with shifting in the triaxial direction or/and rotation. A positioning device can be used to control the positions of the substrate and the diffraction grating for the movements in the X, Y, and Z-axes directions and rotation. The positioning device may be a piezo stage. For example, Melles Griot, 17MAX301 may be used.

(b) The processing conditions can be changed depending on the exposure conditions and exposure time. Resin cures when the exposure dose reaches or exceeds the light curing threshold. Curing is controlled by the exposure time.

(c) The irradiation light vertically enters the substrate surface.

(d) The Talbot distance is determined by Formula 1.

This results in the following.

(i) Adjacent processing areas are connected by reducing the Talbot distance.

(ii) Prior and subsequent processing areas are connected by controlling a periodic distance.

(iii) Adjacent processing areas are made independent of each other by increasing the Talbot distance.

(iv) Prior and subsequent processing areas are independent of each other by controlling the periodic distance.

Examples

Hereinafter, the present invention will be described more specifically by way of examples. However, the present invention is not limited to the following examples.

(Example 1)

The experiment was performed in the following manner.

(1) A resin layer 12a made of a UV curable resin SIPR-3251-6.0 (manufactured by Shin-Etsu Chemical Co., Ltd.) having a uniform thickness was formed on a buffer layer 11 on a substrate 10 using a spin coater. The thickness was 6 $\mu$m (FIG. 3A).
(2) The resin layer 12a formed in (1) was placed on a hot plate 14 and prebaked (heated) at 100°C for 2 minutes to volatilize a solvent contained in the resin layer 12a to form a resin layer 12b (FIG. 3B).
(3) A polycarbonate diffraction grating 15 (pitch width: 747 nm) having a refractive index n of 1.59 was placed on the upper surface of the resin layer 12b obtained in (2). The resin layer was vertically irradiated with light 16 of an ultraviolet LED surface light source (wavelength $\lambda$ = 360 nm) two times, with shifting in the X-axis direction of 0.5 × d (the unit is the same as the unit d and may be an arbitrary unit) to form a pattern in a resin layer 12c (FIG. 3C). At this time, the Formula 1 above was satisfied.
(4) The resin layer 12c obtained in (3) was chemically reacted with a SIPR-3251 developer (the developer supplied with the resin SIPR-3251) to dissolve a portion where the exposure dose reached or exceeded the light curing threshold of SIPR-3251 to form a resin layer 12d (FIG. 3D). Then, the resin layer 12d was chemically reacted with the developer by spin coating to dissolve a portion 18 where the ultraviolet light (UV) exposure dose reached or exceeded the energy ray curing threshold and cure a resin portion 19 where the exposure dose was below the curing threshold. Thus, a photoresist resin layer 12e was formed to have the pores 18 in the resin portion 19.
(5) The resin 19 obtained in (4) was washed with pure water to remove the dissolved portion to obtain a microstructure (FIG. 3F).

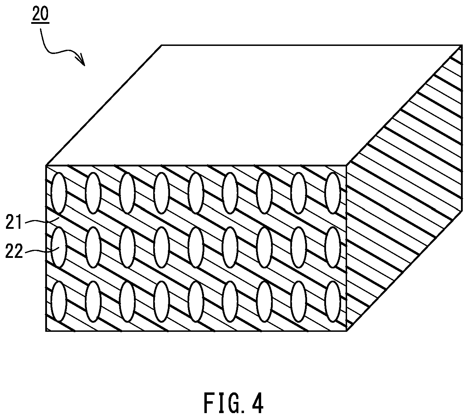

FIG. 4 shows an obtained microstructure (sheet) 20, in which closed pores 22 are regularly formed with periodicity inside a resin portion 21.

(Examples 2 to 7)

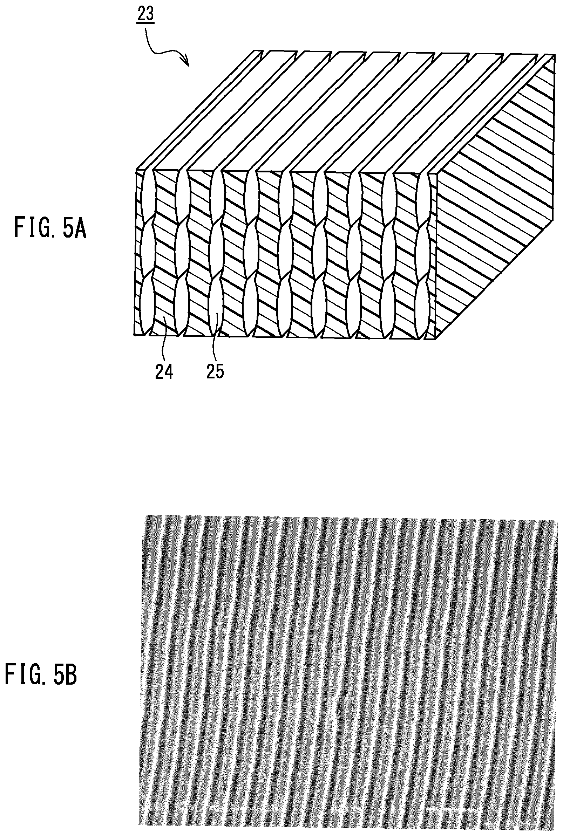

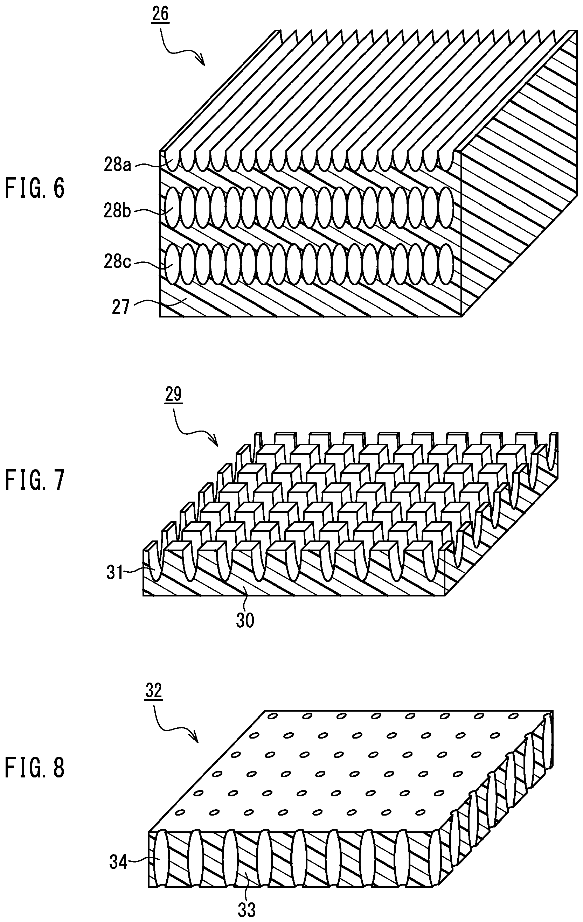

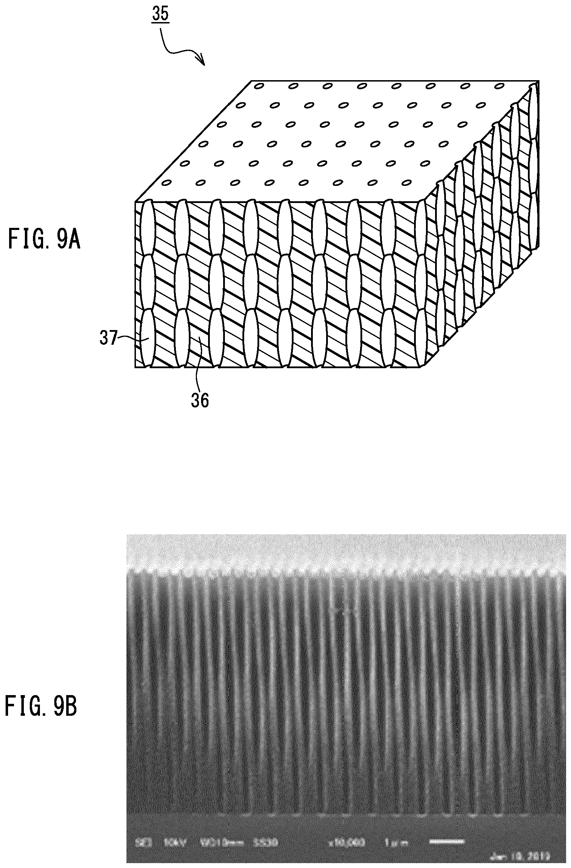

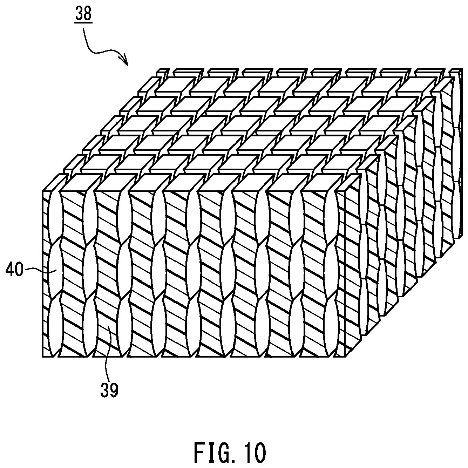

Microstructures of Examples 2 to 7 were produced in the same manner as in Example 1 except for conditions described in Table 2.
Tables 2 and 3 summarize the conditions and results. FIG. 5A is a schematic perspective view illustrating the inside of a microstructure of Example 2, and FIG. 5B is a photograph of the same. FIG. 6 is a schematic perspective view illustrating the inside of a microstructure of Example 3. FIG. 7 is a schematic perspective view illustrating the inside of a microstructure of Example 4. FIG. 8 is a schematic perspective view illustrating the inside of a microstructure of Example 5. FIG. 9A is a schematic perspective view illustrating the inside of a microstructure of Example 6, and FIG. 9B is a photograph of the same. FIG. 10 is a schematic perspective view illustrating the inside of a microstructure of Example 7. In FIGS. 5A to 10, reference numerals 20, 23, 26, 29, 32, 35, and 38 indicate microstructures, 21, 24, 27, 30, 33, 36, and 39 indicate resin portions, and 22, 25, 28, 31, 34, 37, and 40 indicate pores.

[Table 2]

| | | Example 1 | Example 2 | Example 3 | Example 4 |
|---|---|---|---|---|---|
| Material of structure | | UV curable resin | UV curable resin | UV curable resin | UV curable resin |
| Light source | Type | Ultraviolet light | Ultraviolet light | Ultraviolet light | Ultraviolet light |
| | Wavelength (nm) | $\lambda$ = 360 | $\lambda$ = 360 | $\lambda$ = 360 | $\lambda$ = 360 |

(continued)

|  |  | Example 1 | Example 2 | Example 3 | Example 4 |
|---|---|---|---|---|---|
| Optical filter | Height of diffraction grating (h) (nm) | 150 | 150 | 150 | 150 |
|  | Pitch of diffraction grating (d) (nm) | 747 | 747 | 747 | 747 |
|  | Duty cycle of diffraction grating | 0.5 | 0.5 | 0.5 | 0.5 |
|  | Material | Polycarbonate | Polycarbonate | Polycarbonate | Polycarbonate |
| Distance between optical filter and structure (1) (nm) | | 785.9 | 785.9 | 0 | 0 |
| Parameter of Talbot effect | Talbot distance (nm) $Zt = (2nd^2) / \lambda$ | 3143.7 | 3143.7 | 3143.7 | 3143.7 |
| Application of UV curable resin | Rotation speed of spin coater (rpm) | 3000 | 3000 | 3000 | 3000 |
|  | Thickness of resin layer ($\mu$m) | 6 | 6 | 6 | 2 |
| Prebaking | Temperature (°C) | 100 | 100 | 100 | 100 |
|  | Time (min) | 2 | 2 | 2 | 2 |
| Light exposure | Total exposure dose (mJ/cm$^2$) | 80 | 150 | 160 | 150 |
|  | The number of times of exposure (times) | 2 | 2 | 4 | 2 |
|  | Moving condition of each exposure | 1st: 0 2nd: 0.5 d in the X-axis direction | 1st: 0 2nd: 0.5 d in the X-axis direction | 1st: 0 2nd: 0.25 d in the X-axis direction 3rd: 0.25 d in the X-axis direction 4th: 0.25 d in the X-axis direction | 1st: 0 2nd: 90 degree rotation |
| Shape of structure | | FIG. 4 | FIGS. 5A and 5B | FIG. 6 | FIG. 7 |

[Table 3]

|  |  | Example 5 | Example 6 | Example 7 |
|---|---|---|---|---|
| Material of structure | | UV curable resin | UV curable resin | UV curable resin |
| Light source | Type | Ultraviolet light | Ultraviolet light | Ultraviolet light |
|  | Wavelength (nm) | $\lambda = 360$ | $\lambda = 360$ | $\lambda = 360$ |

(continued)

|  |  | Example 5 | Example 6 | Example 7 |
|---|---|---|---|---|
| Optical filter | Height of diffraction grating (h) (nm) | 150 | 150 | 150 |
|  | Pitch of diffraction grating (d) (nm) | 747 | 747 | 747 |
|  | Duty cycle of diffraction grating | 0.5 | 0.5 | 0.5 |
|  | Material | Polycarbonate | Polycarbonate | Polycarbonate |
| Distance between optical filter and structure (l) (nm) |  | 785.9 | 785.9 | 785.9 |
| Parameter of Talbot effect | Talbot distance (nm) $Zt = (2nd^2) / \lambda$ | 3143.7 | 3143.7 | 3143.7 |
| Application of UV curable resin | Rotation speed of spin coater (rpm) | 3000 | 3000 | 3000 |
|  | Thickness of resin layer ($\mu$m) | 2 | 6 | 6 |
| Prebaking | Temperature (°C) | 100 | 100 | 100 |
|  | Time (min) | 2 | 2 | 2 |
| Light exposure | Exposure dose (mJ/cm$^2$) | 150 | 200 | 300 |
|  | The number of times of exposure (times) | 2 | 4 | 4 |
|  | Moving condition of each exposure | 1st: 0 2nd: 90 degree rotation | 1st: 0 2nd: 0.51 in the Z-axis direction 3rd: 90 degree rotation 4th: 0.51 in the Z-axis direction | 1st: 0 2nd: 0.5 d in the X-axis direction 3rd: 90 degree rotation 4th: 0.5 d in the Y-axis direction |
| Shape of structure |  | FIG. 8 | FIGS. 9A and 9B | FIG. 10 |

The above examples indicate that multiple exposure with shifting in the triaxial direction and/or rotation of energy ray obtained by the Talbot effect enables formation of pores in structures and microfabrication of structures having controlled periodicity to the inside.

Industrial Applicability

The microstructures of the present invention having a resin layer in which grooves, through pores, open cells, and the like are formed, are applicable to photonic structures including filters, biomimetic structures, functional members, etc.

Description of Reference Numerals

1, 16 Ultraviolet light (UV)
2, 15 Optical filter (exposure mask)
3 Photoresist resin
4, 5a, 5b Light exposed portion
6 Connected light exposed portion
10 Substrate
11 Buffer layer
12a-12f Photoresist resin layer
13 Photoresist resin liquid
14 Hot plate
7, 17 Exposure pattern
18 Pore
19 Resin portion
20, 23, 26, 29, 32, 35, 38 Microstructure
21, 24, 27, 30, 33, 36, 39 Resin portion
22, 25, 28, 31, 34, 37, 40 Pore

## Claims

1. A microstructure comprising pores on its surface or inside,

   wherein the microstructure is a sheet comprising an energy ray active resin, the pores are formed in a vertical array,
   the pores in the microstructure are in a formation pattern with a Talbot distance being specified by Formula 1 below:

   $$[\text{Formula 1}]$$

   $$Z_T = (2nd^2) / \lambda$$

   where $Z_T$ represents a Talbot distance (nm), n represents a refractive index, d represents a pitch distance (nm), and $\lambda$ represents a light wavelength (nm), and
   the pores have a periodic shape in the planar direction.

2. The microstructure according to claim 1, wherein the energy ray active resin is a resist resin.

3. The microstructure according to claim 1 or 2, wherein the energy ray active resin is a positive resist resin.

4. The microstructure according to any of claims 1 to 3, wherein the periodic shape satisfies a grating pitch of wavelength $\lambda \leq$ grating pitch d and a pitch duty cycle of 0.2 to 0.7.

5. The microstructure according to any of claims 1 to 4, wherein the pores on the surface or inside of the microstructure are at least one selected from closed cells, pores penetrating through the front and back surfaces of the microstructure, grooves, and holes.

6. The microstructure according to any of claims 1 to 5, wherein the periodic shape is a shape with regularity.

7. A method for producing the microstructure according to any of claims 1 to 6, comprising:

   (1) applying an energy ray active resin to a substrate in a uniform thickness;
   (2) prebaking (heating) the applied energy ray active resin layer;
   (3) forming a pattern in the energy ray active resin layer obtained in (2) by placing a diffraction grating on an upper surface of the resin layer, and vertically irradiating the resin layer with energy ray through multiple exposures including exposure with at least one movement of the diffraction grating selected from rotation and shifting;
   (4) chemically reacting the resin layer obtained in (3) with a developer to dissolve a portion where an energy ray exposure dose reaches or exceeds an energy ray curing threshold and cure a portion where the exposure dose is below the curing threshold, or to cure a portion where an energy ray exposure dose reaches or exceeds an energy ray curing threshold and dissolve a portion where the exposure dose is below the curing threshold; and (5) washing the substrate obtained in (4) with pure water to remove the dissolved portion to obtain a microstructure.

FIG. 1A

FIG. 1B

FIG. 2A FIG. 2B

FIG. 3A   FIG. 3B   FIG. 3C

FIG. 3D   FIG. 3E   FIG. 3F

EP 4 057 067 A1

FIG. 4

FIG. 5A

FIG. 5B

FIG. 6

28a

28b

28c

27

26

FIG. 7

29

31

30

FIG. 8

32

34

33

FIG. 9A

35

37

36

FIG. 9B

FIG. 10

## INTERNATIONAL SEARCH REPORT

| | International application No. |
|---|---|
| | PCT/JP2020/039865 |

A.   CLASSIFICATION OF SUBJECT MATTER
G03F 7/20(2006.01)i; G02B 1/02(2006.01)i; G02B 5/00(2006.01)i
FI: G03F7/20 501; G02B5/00 Z; G02B1/02

According to International Patent Classification (IPC) or to both national classification and IPC

B.   FIELDS SEARCHED

Minimum documentation searched (classification system followed by classification symbols)
G03F7/20-7/24; G03F9/00-9/02; H01L21/027; H01L21/30; G02B5/00-5/136

Documentation searched other than minimum documentation to the extent that such documents are included in the fields searched
| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>A | JP 2007-523468 A (THE BOARD OF TRUSTEES OF THE UNIVERSITY OF ILLINOIS) 16 August 2007 (2007-08-16) paragraphs [0006]-[0007], [0063], [0084], [0114], [0119]-[0120], fig. 6 | 1-6<br>7 |
| X<br>A | JP 2013-16696 A (DAINIPPON PRINTING CO., LTD.) 24 January 2013 (2013-01-24) paragraphs [0002]-[0003], [0008], [0042]-[0043], [0118]-[0119], fig. 25 | 1-6<br>7 |

☒   Further documents are listed in the continuation of Box C.   ☒   See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 25 December 2020 (25.12.2020) | 12 January 2021 (12.01.2021) |

| Name and mailing address of the ISA/<br>Japan Patent Office<br>3-4-3, Kasumigaseki, Chiyoda-ku,<br>Tokyo 100-8915, Japan | Authorized officer<br><br><br>Telephone No. |
|---|---|

Form PCT/ISA/210 (second sheet) (January 2015)

<div align="center">

**INTERNATIONAL SEARCH REPORT**

</div>

| | International application No. |
|---|---|
| | PCT/JP2020/039865 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>A | 中西 弘樹、他，タルボット効果による多重露光リソグラフィを用いた3次元ナノ周期構造の作製，Journal of the Japan Society for Precision Engineering, 05 August 2019, vol. 85, no. 8, pp. 710-716, sections "2. Fabrication method of 3D nano-periodic structure using Talbot effect", "4. Fabrication process of 3D nano-periodic structure", "5. The results of construction of periodic structure", "6. Fabrication of 3D nano-periodic structure by multiple exposure", (NAKANISHI, Hiroki et al., "Fabrication of 3D Nano-Periodic Structure Using Multiple Exposure Lithography by Talbot Effect") | 1-2, 4-7<br>3 |
| X | 中西 弘樹、他，タルボット効果を用いた広範囲3次元リソグラフィ（第2報）、多重露光を援用した3次元ナノ周期構造の作製， 2019年度精密工学会春季大会学術講演会講演論文集，04 September 2019, L21, sections "1. Introduction", "2. Principle of fabrication of 3D nano-periodic structure by multiple exposure", "3. Multiple exposure process for fabrication of 3D nano periodic structure", (NAKANISHI, Hiroki et al., "Large-area nanofabrication by three-dimensional lithography using Talbot effect (2nd report), Fabrication of three-dimensional nano periodic structure using multiple exposure", Lecture proceedings of Academic lecture conference of the 2019 JSPE Spring Meeting) | 1-7 |
| A | WO 2016/190247 A1 (ASAHI GLASS CO., LTD.) 01 December 2016 (2016-12-01) entire text, all drawings | 1-7 |
| A | JP 2013-161919 A (TOSHIBA CORP.) 19 August 2013 (2013-08-19) entire text, all drawings | 1-7 |
| A | WO 2015/008731 A1 (GIGAPHOTON INC.) 22 January 2015 (2015-01-22) entire text, all drawings | 1-7 |
| A | JP 2006-330085 A (MATSUSHITA ELECTRIC INDUSTRIAL CO., LTD.) 07 December 2006 (2006-12-07) entire text, all drawings | 1-7 |
| A | JP 2011-114125 A (TOSHIBA CORP.) 09 June 2011 (2011-06-09) entire text, all drawings | 1-7 |
| A | WO 2013/029985 A2 (SUSS MICROTEC LITHOGRAPHY GMBH) 07 March 2013 (2013-03-07) entire text, all drawings | 1-7 |

Form PCT/ISA/210 (continuation of second sheet) (January 2015)

INTERNATIONAL SEARCH REPORT

Information on patent family members

International application No.

PCT/JP2020/039865

| Patent Documents referred in the Report | Publication Date | Patent Family | Publication Date |
|---|---|---|---|
| JP 2007-523468 A | 16 Aug. 2007 | US 2006/0286488 A1 paragraphs [0007]-[0008], [0080], [0101], [0131], [0140]-[0141], fig. 6 WO 2005/054119 A2 EP 1700161 A2 KR 10-2006-0109477 A CN 1890603 A IL 175731 D | |
| JP 2013-16696 A | 24 Jan. 2013 | (Family: none) | |
| WO 2016/190247 A1 | 01 Dec. 2016 | (Family: none) | |
| JP 2013-161919 A | 19 Aug. 2013 | (Family: none) | |
| WO 2015/008731 A1 | 22 Jan. 2015 | US 2016/0187788 A1 entire text, all drawings | |
| JP 2006-330085 A | 07 Dec. 2006 | (Family: none) | |
| JP2011-114125 A | 09 Jun. 2011 | US 2011/0122390 A1 entire text, all drawings | |
| WO 2013/029985 A2 | 07 Mar. 2013 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016190247 A
- JP 2015169803 A
- JP 2006343671 A

**Non-patent literature cited in the description**

- Fabricating of metallic three-dimensional nanostructure using Talbot effect (1st report), Influence analysis of grating shape and verification of fabrication process. *Proceedings of the Japan Society for Precision Engineering in Spring,* 2016
- Three-dimensional lithography in a large area using Talbot effect (1st report), Fabrication of functional devices using wave-front control and standing-wave field. *Proceedings of the Japan Society for Precision Engineering in Spring,* 2017
- Three-dimensional lithography in a large area using Talbot effect (2nd report), Fabrication of 3D nano-periodic structure using multiple exposure. *Proceedings of the Japan Society for Precision Engineering in Spring,* 2019
- Fabrication of 3D Nano-Periodic Structure Using Multiple Exposure Lithography by Talbot Effect. *Journal of the Japan Society for Precision Engineering,* 2019, vol. 85 (8